# EUROPEAN PATENT APPLICATION

(11) **EP 4 019 268 A1**
(43) Date of publication of application: **29.06.2022**
(21) Application number: 20858290.8
(22) Date of filing: 27.07.2020
(51) Int. Cl.: B41N 1/12, B41C 1/00, B41M 1/04, G03F 7/00, G03F 7/027, G03F 7/031, G03F 7/095

(54) **FLEXOGRAPHIC PRINTING PLATE**

(30) Priority: 23.08.2019 JP 2019152852
(71) Applicant: TOYOBO CO., LTD., Osaka-shi Osaka 5300001 (JP)
(72) Inventor: YOSHIMOTO, Kazuya, Okayama-shi, Okayama 704-8194 (JP); HIGO, Eri, Otsu-shi, Shiga 520-0292 (JP); NAKAMORI, Masahiko, Okayama-shi, Okayama 704-8194 (JP)
(74) Representative: Müller-Boré & Partner Patentanwälte PartG mbB
(86) International application number: PCT/JP2020/028710
(87) International publication number: WO 2021/039233

(57) **Abstract**

The present invention provides a flexographic printing plate in which the problem of ink entanglement, i.e., the direct connection of ink on a dot convex part to ink on an adjacent dot convex part, is reduced. A flexographic printing plate obtained from a flexographic printing plate precursor comprising at least a support (A), a photosensitive resin layer (B) and a heat-sensitive mask layer (C) which are laminated in this order, wherein, on a surface of the printing plate, there are provided dot convex parts, a dot valley part formed between the dot convex parts, and a floor part, and wherein a side surface of the dot valley part and the floor part have been subjected to the same finishing exposure treatment and the same exposure treatment using a germicidal lamp, characterized in that the adhesion force of the floor part on the printing plate is 2.0 N/mm² or less.

## Description

### Technical Field

The present invention relates to a flexographic printing plate which is capable of reducing an ink entanglement in which ink on a dot convex part and ink on an adjacent dot convex part are connected to each other.

### Background Art

Flexographic printing is a printing method in which an ink is applied onto convex parts on a printing plate and then the printing plate is pressed against a substrate so as to transfer the ink from the printing plate to the substrate. A printing plate used in flexographic printing is relatively soft and can fit to various shapes, and therefore makes it possible to print on wide varieties of substrates. Examples of the substrate include a packaging film, label paper, drink carton, a paper-made container, an envelope and cardboard. Particularly for a substrate having a rough surface, flexographic printing is mainly employed. Furthermore, flexographic printing can utilize a water-based or alcohol-based ink from which the emission amount of VOCs (volatile organic compounds) is small. Therefore, flexographic printing is a highly environment-friendly printing method. Due to the above-mentioned advantages, i.e., the adaptability to substrates and the environmental friendliness, gravure printing and offset printing are increasingly shifting to flexographic printing.

On the other hand, flexographic printing has a problem of ink entanglement, i.e., a phenomenon wherein ink on a dot convex part is connected to ink on an adjacent dot convex part on a printing plate. Ink entanglement is caused by the following mechanism. When ink is accumulated in a valley part formed between dots on a printing plate in an amount exceeding a certain level, the ink on a dot convex part is directly connected to the ink on an adjacent dot convex part, and the connected ink is transferred onto an object to be printed. Ink entanglement causes a large deterioration in printing quality. Therefore, in general, when ink entanglement occurs, the operation of a printing machine is stopped and the printing plate is washed. Many number of sheets of paper are wasted when the operation of the printing machine is stopped. Ink entanglement occurs more prominently when a water-based ink is used compared with the case where an UV ink is used. This is because a water-based ink generally has a lower viscosity than an UV ink, and therefore the water-based ink on a dot convex part tends to move to a dot valley part more easily.

As to a method for preventing the occurrence of ink entanglement, methods have been proposed, in which the surface tension of a surface of a printing plate is decreased by adding a silicone to a photosensitive resin layer or blowing a modified silicone against a surface of a printing plate so as to inhibit the movement of ink from a dot convex part to a dot valley part (see Patent Documents 1 to 3). In these methods, although the inhibition effect for UV inks is satisfactory, the inhibition effect for water-based inks is insufficient. Furthermore, these methods decrease the surface tension of a surface of a printing plate, and therefore the ink transfer performance on a solid-printed part may be deteriorated.

In these situations, a flexographic printing plate which rarely undergoes the problem of ink entanglement, i.e., the connection of ink on a dot convex part to ink on an adjacent dot convex part, regardless of the viscosity of the ink has been still keenly demanded.

### Prior Art Documents

### Patent Documents

Patent Document 1: WO 07/116941
Patent Document 2: Japanese Patent No. 5751492
Patent Document 3: Japanese Patent No. 5601606

### Disclosure of the Invention

### Problem that the Invention is to Solve

The present invention has been made in these situations of the prior art techniques. The object of the present invention is to provide a flexographic printing plate in which the problem of ink entanglement, i.e., the direct connection of ink on a dot convex part to ink on an adjacent dot convex part, is reduced.

### Means for Solving the Problem

For the purpose of achieving the above-mentioned object, the present inventors have made extensive and intensive studies about the causes of ink entanglement and the countermeasures for the ink entanglement. As a result, it was found that the ink entanglement is caused as a result of the accumulation of ink in a dot valley part located between adjacent dot convex parts. For preventing the ink entanglement, it is effective to reduce the adhesion force of a side surface of the dot valley part on a printing plate so as to inhibit the movement of the ink to the dot valley part. In this regard, it is positionally difficult to accurately measure the adhesion force of a side surface of a dot valley part on a printing plate. Therefore, in the present invention, the adhesion force of a floor part on the printing plate is employed as a measure instead. This is because the adhesion force of a floor part on the printing plate shows substantially the same adhesion force as that of the side surface of a dot valley part.

In order to reduce the adhesion force of a side surface of the dot valley part, it was found that the following countermeasures are suitable: a photopolymerization initiator is added in a larger amount compared with the conventional flexographic printing plate, in a photosensitive resin composition constituting a photosensitive resin layer, an ethylenically unsaturated compound having a low molecular weight is added in a specified amount as an ethylenically unsaturated compound component in the photosensitive resin composition, and the ratio of the mass of the photopolymerization initiator to the mass of the ethylenically unsaturated compound having a low molecular weight is adjusted to a higher value compared with the conventional flexographic printing plate; as to the ethylenically unsaturated compound component in the photosensitive resin composition, an ethylenically unsaturated compound having a high molecular weight is added in addition to the ethylenically unsaturated compound having a low molecular weight; and as to a photopolymerization initiator component, specific two types of photopolymerization initiators are used. Based on these findings, the present invention has been accomplished.

In summary, the present invention has the following configurations (1) to (7).
(1) A flexographic printing plate obtained from a flexographic printing plate precursor comprising at least a support (A), a photosensitive resin layer (B) and a heat-sensitive mask layer (C) which are laminated in this order, wherein, on a surface of the printing plate, there are provided dot convex parts, a dot valley part formed between the dot convex parts, and a floor part, and wherein a side surface of the dot valley part and the floor part have been subjected to the same finishing exposure treatment and the same exposure treatment using a germicidal lamp, characterized in that the adhesion force of the floor part on the printing plate is 2.0 N/mm² or less.
(2) The flexographic printing plate according to (1), wherein a photosensitive resin composition constituting the photosensitive resin layer (B) comprises (a) a polymer prepared by polymerizing a conjugated diene, (b) an ethylenically unsaturated compound and (c) a photopolymerization initiator, wherein the content of the photopolymerization initiator (c) in the photosensitive resin composition is 2 to 9% by mass, wherein the ethylenically unsaturated compound (b) includes a (meth)acrylate compound (i) having a number average molecular weight of 100 to 600, wherein the content of the (meth)acrylate compound (i) having a number average molecular weight of 100 to 600 in the photosensitive resin composition is 5 to 16% by mass, and wherein the ratio of the mass of the photopolymerization initiator (c) and the mass of the (meth)acrylate compound (i) having a number average molecular weight of 100 to 600 in the photosensitive resin composition is within the range of 0.20 to 0.55.
(3) The flexographic printing plate according to (2), wherein the ethylenically unsaturated compound (b) further includes a (meth)acrylate compound (ii) having a number average molecular weight of more than 600 and not more than 20,000, and wherein the content of the (meth)acrylate compound (ii) having a number average molecular weight of more than 600 and not more than 20,000 in the photosensitive resin composition is 5 to 25% by mass.
(4) The flexographic printing plate according to (2) or (3), wherein the photopolymerization initiator (c) includes two types of compounds which are a benzyl alkyl ketal compound and a benzophenone compound, and wherein the ratio of the mass of the benzyl alkyl ketal compound to the mass of the benzophenone compound is within the range of 99:1 to 80:20.
(5) The flexographic printing plate according to any of (1) to (4), wherein the flexographic printing plate precursor has an oxygen barrier layer (D) between the photosensitive resin layer (B) and the heat-sensitive mask layer (C).
(6) The flexographic printing plate according to any of (1) to (5), wherein the flexographic printing plate has been obtained by developing the flexographic printing plate precursor using a water-based developing solution.
(7) A flexographic printing method, characterized in that the method uses the flexographic printing plate according to any of (1) to (6).

### Advantages of the Invention

The flexographic printing plate according to the present invention is configured such that the adhesion force of a floor part (the adhesion force of a dot side surface) is reduced and, as a result, the adhesion force of a side surface of a dot valley part formed between adjacent dot convex parts on a printing plate is reduced compared with the conventional flexographic printing plate. Therefore, ink is inhibited from moving to the dot valley part, and therefore the ink entanglement in which ink on a dot convex part and ink on an adjacent dot convex part are directly connected to each other can be inhibited effectively.

### Brief Description of the Drawings

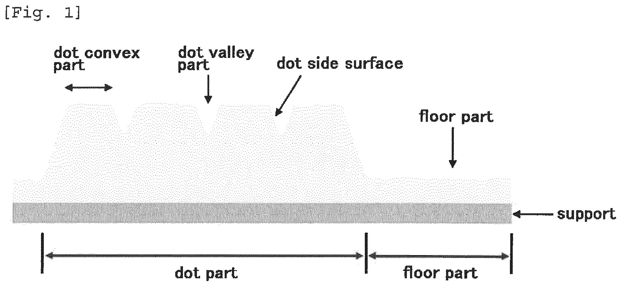

FIG. 1 shows a schematic diagram for explaining a dot part, a dot convex part, a dot valley part, a dot side surface, and a floor part with reference to a cross sectional view of a printing plate.

### Best Mode for Carrying Out the Invention

The flexographic printing plate according to the present invention is a flexographic printing plate obtained from a flexographic printing plate precursor comprising at least a support (A), a photosensitive resin layer (B) and a heat-sensitive mask layer (C) which are laminated in this order. Specifically, the flexographic printing plate according to the present invention is a printing plate obtained by exposing and developing such a flexographic printing plate precursor.

A dot part, a dot convex part, a dot valley part, a dot side surface, and a floor part on a printing plate which are mentioned in the present invention are illustrated in the cross-sectional view of a printing plate shown in FIG. 1. In general, the surface of a printing plate is roughly divided into a dot part and the rest of the surface which is called a "floor part". Dots are parts that form an image. An ink is transferred to a substrate by applying the ink on convex parts of the dots and pressing the dot convex parts against the substrate, thereby producing an image. Meanwhile, floor parts have a cushioning function, and have a role to improve printing quality. The floor parts are cured layers formed by back exposure, i.e., the irradiation of the whole area of a back surface of a printing plate precursor through the support with an active ray in the production of a flexographic printing plate from the flexographic printing plate precursor. Each of the floor parts has approximately flat surface. The preferred thickness of each of the floor parts may vary depending on the type of the substrate to be printed. Therefore, it is important to vary the thickness of each of the floor parts depending on the type of the substrate. The control of the thickness of the floor part can be performed by varying the conditions for the back exposure. More specifically, when the amount of back exposure is increased, the floor part becomes thicker; while when the amount of back exposure is decreased, the floor part becomes thinner. Back exposure is performed for controlling the thickness of the floor part, and does not substantially affect the adhesiveness of the floor part. As shown in FIG. 1, the dot part is a part where a plurality of dot convex parts are gathered. Between adjacent dot convex parts, a dot valley part having right and left side surfaces is formed. As shown in FIG. 1, the depth of the dot valley part (i.e., the difference between the height of the top of the dot convex part and the height of the lowest point of the dot valley part) is smaller than the depth of the floor part (i.e., the difference between the height of the top of the dot convex part and the height of the floor part). As mentioned above, ink placed on a dot convex part tends to easily move to and be accumulated in the dot valley part. As a result, the problem of ink entanglement tends to occur.

The flexographic printing plate according to the present invention is configured in such a way that, when dots are formed on a printing plate, the adhesion force of a side surface part of a dot valley part formed between adjacent dot convex parts (for convenience, the adhesion force of a floor part is employed as a measure instead) is reduced to 2.0 N/mm² or less. Because the flexographic printing plate is configured in the above-mentioned way, it becomes possible to effectively inhibit the movement of ink on adjacent dot convex parts to a dot valley part formed between the dot convex parts and the accumulation of ink in the dot valley part. As a result, the problem of ink entanglement, i.e., the problem that ink placed on the adjacent dot convex parts are directly connected to each other, can be prevented effectively. In the above statements, the adhesion force of a floor part on a printing plate is defined instead of the adhesion force of a dot side surface part on the printing plate. This is because the measurement of the adhesion force of the dot side surface part is positionally difficult, and, even when a measurement value of the adhesion force of a floor part (that has been subjected to the same finishing exposure treatment and the same exposure treatment using a germicidal lamp as the dot side surface part) is employed, substantially the same adhesion force as the dot side surface part can be obtained. Therefore, in the belowmentioned explanation, it is to be understood that the adhesion force (adhesiveness) of a "floor part" is equivalent to the adhesion force (adhesiveness) of a "dot side surface part".

The (A) support used in flexographic printing plate precursor is preferably made from a material being flexible and having a superior dimension stability. Examples thereof include: a support made of metal, such as steel, aluminum, copper and nickel, and a support made of a thermoplastic resin, such as a polyethylene terephthalate film, a polyethylene naphthalate film, a polybutylene terephthalate film and a polycarbonate film. Among these, the polyethylene terephthalate film, which has the superior dimension stability and a sufficiently high viscoelasticity, is in particular preferably used. A thickness of the support is set to 50 to 350 µm, preferably, to 100 to 250 µm, from viewpoints of mechanical properties, shape stability and handling characteristics during manufacturing of a printing plate. Moreover, if necessary, an adhesive may be arranged between the support (A) and the photosensitive resin layer (B) in order to improve an adhesive property between them.

The photosensitive resin composition constituting the photosensitive resin layer (B) used in flexographic printing plate precursor comprises (a) a polymer prepared by polymerizing a conjugated diene, (b) an ethylenically unsaturated compound and (c) a photopolymerization initiator, and if necessary, comprises an additive such as a plasticizer, a hydrophilic compound, an ultraviolet ray absorber, a surface tension modulator, a thermal polymerization inhibitor, a dye, a pigment, a flavoring agent, and an antioxidant agent. The present invention is particularly characterized in that: in the photosensitive resin composition constituting the photosensitive resin layer (B), the composition of the ethylenically unsaturated compound (b) is specifically designed; and the photopolymerization initiator (c) is used at a mass-based ratio that is larger than the ratio actually employed in the conventional techniques.

As to the polymer prepared by polymerizing the conjugated diene (a), a conventional known synthetic highmolecular-weight compound that has been used in a printing plate precursor can be used. Examples of the polymer include a polymer prepared by polymerizing a conjugated diene hydrocarbon and a copolymer prepared by copolymerizing a conjugated diene hydrocarbon and a monoolefin unsaturated compound. Specific examples of the polymer include a butadiene polymer, an isoprene polymer, a chloroprene polymer, a styrene-butadiene copolymer, a styrene-butadiene-styrene copolymer, a styrene-isoprene copolymer, a styrene-isoprene-styrene copolymer, a styrenechloroprene copolymer, an acrylonitrile-butadiene copolymer, an acrylonitrile-isoprene copolymer, a (methyl methacrylate)-butadiene copolymer, a (methyl methacrylate)-isoprene copolymer, an acrylonitrile-butadiene-styrene copolymer, and an acrylonitrile-isoprene-styrene copolymer. Among these polymers, a butadiene polymer is preferably used, from the viewpoint of the properties of flexographic printing plates, i.e., repulsion elasticity of a surface of a printing plate, high elongation properties, resin plate hardness, dimensional stability during unexposed state, and easy availability. These polymers may be used singly, or two or more of them may be used in combination. It is preferred that the content of the component (a) in the photosensitive resin composition that forms the photosensitive resin layer (B) is within the range of 40 to 70% by mass.

As to the ethylenically unsaturated compound (b), a conventional known one that has been used in a printing plate precursor can be used. It is preferred to include a (meth)acrylate compound having a number average molecular weight of 100 to 600 (hereinafter, it may be simply referred to as a (meth)acrylate compound having a low molecular weight) (i). In addition, it is preferred to further include a (meth)acrylate compound having a number average molecular weight of more than 600 and not more than 20,000 (hereinafter, it may be simply referred to as a (meth)acrylate compound having a high molecular weight) (ii). The (meth)acrylate compound having a low molecular weight is crosslinked and cured by the action of a photopolymerization initiator so as to form a dense crosslinked network. The (meth)acrylate compound having a high molecular weight is crosslinked and cured by the action of the photopolymerization initiator so as to form a loose crosslinked network. The number average molecular weight of the former is further preferably 200 to 500, and that of the latter is further preferably 2000 to 10000. As mentioned above, when not only the (meth)acrylate compound having a low molecular weight but also the (meth)acrylate compound having a high molecular weight are contained, the reproducibility of isolated dots and durability during printing cannot be deteriorated even when the photopolymerization initiator (c) is added in a larger amount compared with the conventional flexographic printing plate. This is supposed to be because the toughness of the printing plate is increased by the addition of the (meth)acrylate compound having a high molecular weight in a specified amount. It is preferred that the content of the component (b) in the photosensitive resin composition that forms the photosensitive resin layer (B) is within the range of 10 to 50% by mass.

The content of the (meth)acrylate compound having a high molecular weight in the photosensitive resin composition is preferably 5 to 25% by mass and further preferably 8 to 20% by mass. If the content is less than the above-mentioned range, the durability of printing plate may be deteriorated when the photopolymerization initiator (c) is added in a larger amount. If the content is more than the above-mentioned range, the composite elastic modulus of a solid-printed part may be increased, whereby the ink laydown on a solid-printed part may become insufficient, which may result in a poor quality of printed matters. The content of the (meth)acrylate compound having a low molecular weight in the photosensitive resin composition is preferably 5 to 16% by mass and further preferably 7 to 13% by mass. By adding the (meth)acrylate compound having a low molecular weight in an amount within the above-mentioned range, the adhesiveness of the dot side surface part and the adhesiveness of the floor part can be effectively reduced. However, if the content is less than the above-mentioned range, the effect to reduce the adhesiveness of the dot side surface part and the adhesiveness of the floor part may be insufficient. When the content is more than the above-mentioned range, the composite elastic modulus of the solid-printed part may be increased, whereby the ink laydown on a solid-printed part may become insufficient, which may result in a poor quality of printed matters.

The (meth)acrylate compound having a low molecular weight is not particularly limited, as long as the number average molecular weight of the compound is within the range of 100 to 600 inclusive. Examples of the compound include liner, branched or cyclic monofunctional monomers such as hexyl (meth)acrylate, nonane (meth)acrylate, lauryl (meth)acrylate, stearyl (meth)acrylate, 2-ethyl, 2-butylpropanediol (meth)acrylate, hydroxyethyl (meth)acrylate, 2-(meth)acryloyloxyethyl hexahydrophtalate, 2-(meth)acryloyloxyethyl phtalate, a (meth)acrylic acid dimer, ECH denatured allyl acrylate, benzyl acrylate, caprolactone (meth)acrylate, dicyclopentenyl (meth)acrylate, isobornyl (meth)acrylate and cyclohexyl (meth)acrylate. The examples also include linear branched or cyclic polyfunctional monomers such as hexanediol di(meth)acrylate, nonanediol di(meth)acrylate, 2-butyl-2-ethylpropanediol di(meth)acrylate, neopentyl glycol di(meth)acrylate, neopentylglycol hydroxypivalate di(meth)acrylate, ECH denatured phthalic acid di(meth)acrylate, dicyclopentadiene di(meth)acrylate, tricyclodecanedimethanol di(meth)acrylate, trimethylolpropane tri(meth)acrylate, pentaerythritol tri(meth)acrylate, ECH denatured glycerol tri(meth)acrylate, trimethylolpropane benzoate (meth)acrylate, EO(PO) denatured trimethylolpropane tri(meth)acrylate and dipentaerythritol hexa(meth)acrylate. These compounds may be used singly. Alternatively, two or more of them may be used in combination for the purpose of imparting a desired resin property.

The (meth)acrylate compound having a high molecular weight is not particularly limited, as long as the number average molecular weight of the compound is within the range of more than 600 and not more than 20,000. For example, a butadiene oligomer or an isoprene oligomer each having a (meth)acrylate group attached thereto, and urethane(meth)acrylate are also exemplified. These compounds may be used singly. Alternatively, two or more of them may be used in combination for the purpose of imparting a desired resin property.

The ratio of the mass of the photopolymerization initiator (c) and the mass of the (meth)acrylate compound (i) having a low molecular weight [(mass of the photopolymerization initiator)/(mass of the (meth)acrylate compound having a low molecular weight)] is preferably 0.20 to 0.55. It is more preferably 0.22 to 0.50 and further preferably 0.25 to 0.45. By adjusting this ratio to such a range, the adhesiveness of the dot side surface part and the adhesiveness of the floor part can be satisfied sufficiently. If the ratio is less than the above-mentioned range, the amount of the photopolymerization initiator is too small, and therefore the adhesiveness of the dot side surface part and the adhesiveness of the floor part may not be reduced. If the ratio is more than the above-mentioned range, the amount of the photopolymerization initiator becomes too much in relation to the amount of the (meth) acrylate, and consequently the amount of the (meth)acylate that causes the crosslinking reaction may be insufficient. In this case, the adhesiveness of the dot side surface part and the adhesiveness of the floor part may not be reduced, either.

Examples of the photopolymerization initiator (c) include a benzophenone compound, a benzoin compound, an acetophenone compound, a benzyl compound, a benzoin alkyl ether compound, a benzyl alkyl ketal compound, an anthraquinone compound and a thioxanthone compound. More specific examples include benzophenone, chlorobenzophenone, benzoin, acetophenone, benzyl, benzoin methyl ether, benzoin ethyl ether, benzoin isopropyl ether, benzoin isobutyl ether, benzyl dimethylketal, benzyl diethylketal, benzyl diisopropylketal, anthraquinone, 2-ethylanthraquinone, 2-methylanthraquinone, 2-allylanthraquinone, 2-chloroanthraquinone, thioxanthone and 2-chlorothioxanthone.

The photopolymerization initiator (c) preferably includes two types of compounds which consist of a benzyl alkyl ketal compound and a benzophenone compound. The ratio of the mass of the benzyl alkyl ketal compound to the mass of the benzophenone compound is preferably within the range of 99:1 to 80:20 and further preferably within the range of 97:3 to 85:15. The photopolymerization initiator has an intrinsic optical absorption spectrum. Therefore, by using two types of photopolymerization initiators in combination, it becomes possible to efficiently reduce the adhesiveness of the dot side surface part and the adhesiveness of the floor part. Particularly when two types of photopolymerization initiators are a benzyl alkyl ketal compound and a benzophenone compound, the composite elastic modulus of each dot can be further improved selectively. As to the benzyl alkyl ketal compound, benzyl dimethylketal is preferred. As to the benzophenone compound, benzophenone is preferred. Particularly, benzophenone does not have optical absorption to a lamp to be used in the main exposure (peak wavelength: 370 nm), but has optical absorption to a lamp of a germicidal lamp (peak wavelength: 250 nm). Therefore, when benzophenone is used, the composite elastic modulus of each solid-printed part is not increased with the main exposure light, and the adhesiveness of the dot side surface part and the adhesiveness of the floor part can be reduced by the exposure with a germicidal lamp.

In the present invention, the content of the photopolymerization initiator (c) in the photosensitive resin composition is preferably 2 to 9% by mass, more preferably 2.5 to 7.5% by mass, and further preferably 3 to 7% by mass. As mentioned above, the increase in the content of the photopolymerization initiator to a larger amount compared with the conventional flexographic printing plate can contribute to the reduction of the adhesiveness of the dot side surface part and the adhesiveness of the floor part. Conventionally, it has been believed that, when the content of a photopolymerization initiator is increased, the reach of light in the thickness direction of a printing plate is blocked due to the absorption of light by the photopolymerization initiator after the reaction to thereby deteriorate the reproducibility of isolated dots which is greatly affected by the crosslinking in the thickness direction and deteriorate the durability during printing. For these reasons, conventionally, the content of a photopolymerization initiator in a photosensitive resin composition of about 1% by mass at most has been generally employed in the actual practice. In contrast, in the present invention, by adding a (meth)acrylate compound having a high molecular weight in a specified amount in the photosensitive resin composition, it becomes possible to increase the toughness of a printing plate and to thereby overcome the above-mentioned disadvantages of prior arts (deterioration of reproducibility of isolated dots and deterioration of durability during printing) which occur when a photopolymerization initiator is used in a large amount, and therefore utilize benefit (reduction of the adhesiveness of the dot side surface part and the adhesiveness of the floor part) from the increase in the content of the photopolymerization initiator.

In the present invention, the photosensitive resin composition constituting the photosensitive resin layer (B) to be used in the flexographic printing plate precursor may further contain a silicone compound. By adding a silicone compound, the surface tension of the surface of the printing plate is decreased and thus the ink entanglement can be inhibited effectively. Preferably, the silicone compound is an amino-modified silicone compound having an amino group in the molecule. When the amino-modified silicone compound is used, the effect of preventing the ink entanglement can be sustainably exerted. It is considered that this is because the amino group in the molecule is added to the double bond in the photopolymerizable unsaturated compound by Michael reaction, the silicone compound is fixed in the photosensitive resin layer, and a migration of the silicone compound during printing is blocked. A position of the amino group in the molecule is not limited, and examples thereof include a terminal position and a side chain position. A number of amino groups may be one or more, and the silicone compound may have amino groups at a plurality of sites. The silicone compound may have functional groups other than an amino group. An amino group equivalent in the amino-modified silicone compound is preferably in a range of 500 g/mol to 10,000 g/mol and further preferably in a range of 1,000 g/mol to 5,000 g/mol. The initial ink entanglement-preventing effect may be poor when the amino group equivalent is less than the lower limit. The effect sustainability may be poor when the amino group equivalent exceeds the upper limit. A kinematic viscosity of the amino-modified silicone compound is not particularly limited but is preferably in a range of 20 to 5000 mm²/s and further preferably in a range of 40 to 1000 mm²/s. The ink entanglement-preventing effect may be poor when the kinematic viscosity is less than the lower limit. A dissolution stability may be poor when the kinematic viscosity exceeds the upper limit. As to the silicone compound which is suitable to be used in the present invention, for example, X22 1660B-3 and X22 9409 manufactured by Shin-Etsu Chemical Co., Ltd. are available from the market. Those that are not available from the market can be synthesized, for example, by appropriately referring to a synthesis method disclosed in Japanese Patent Application Laid-Open (JP-A) No. 197486/91, Japanese Patent Application Laid-Open (JP-A) No. 34855/96, Japanese Patent Application Laid-Open (JP-A) No. 2006-213856, and Japanese Patent Application Laid-Open (JP-A) No. 2017-52737. A number average molecular weight of the silicone compound used in the present invention is preferably 500 to 50,000 and more preferably 1,000 to 10,000. The ink entanglement-preventing effect may be insufficient when the number average molecular weight is less than the lower limit. A compatibility with the photosensitive resin may decrease when the number average molecular weight exceeds the upper limit. A content of the silicone compound in the photosensitive resin layer is preferably 0.1% to 10% by mass and more preferably 0.2% to 5% by mass. The ink entanglement-preventing effect may not be sufficiently exerted when the content of silicone compound is less than the lower limit. A mechanical strength of the printing plate may decrease when the content exceeds the upper limit.

The photosensitive resin composition constituting the photosensitive resin layer (B) used in flexographic printing plate precursor comprises (a) a polymer prepared by polymerizing a conjugated diene, (b) an ethylenically unsaturated compound, (c) a photopolymerization initiator and the above-mentioned silicone compound, and if necessary, comprises an additive such as a plasticizer, a hydrophilic compound, an ultraviolet ray absorber, a thermal polymerization inhibitor, a dye, a pigment, a flavoring agent, and an antioxidant agent.

The plasticizer is used for imparting flexibility to the photosensitive resin layer (B) . Examples of the plasticizer include a liquid rubber, an oil, a polyester, and a phosphorus-based compound. Examples of the liquid rubber include liquid polybutadiene, liquid polyisoprene, and a compound prepared by adding a hydroxyl group or a carboxyl group to each of these compounds. Examples of the oil include paraffin, naphthene and an aroma oil. An example of the polyester is an adipic acid-based polyester. An example of the phosphoric acid-based compound is a phosphoric acid ester. Among these compounds, a liquid polybutadiene and a liquid polybutadiene having a hydroxyl group or a carboxyl group attached thereto are preferred from the viewpoint of compatibility with the polymer prepared by polymerizing a conjugated diene. When the development is performed with a water-based developing solution, a liquid polybutadiene having a hydroxyl group or a carboxyl group attached thereto is particularly preferred. The content of the plasticizer in the photosensitive resin composition is preferably 5 to 15% by mass.

The hydrophilic compound is used for improving the developability of the photosensitive resin layer (B) with the water-based developing solution. Examples of the hydrophilic compound include a carboxylic acid, a carboxylic acid salt, a sulfonic acid, a sulfonic acid salt, an acrylic polymer having a hydrophilic group (e.g., a hydroxyl group, an amino group, a phosphate group, an ethylene oxide group, a propylene oxide group), a urethane polymer, a polyamide polymer, and a polyester polymer. In addition, a known surfactant may also be used. Among these compounds, a urethane polymer having a carboxylate group is preferred from the viewpoint of the developability in a water-based developing solution. The content of the hydrophilic compound in the photosensitive resin composition is preferably 1 to 15% by mass.

The ultraviolet ray absorber is used for improving the exposure latitude of the photosensitive resin layer (B). Examples of the ultraviolet ray absorber include a benzophenone-based compound, a salicylate-based compound, a benzotriazole-based compound, an acrylonitrilebased compound, a metal complex salt-based compound, a hindered amine-based compound, an anthraquinone-based compound, an azo-based compound, a coumarin-based compound, and a furan-based compound. Among these compounds, a benzotriazole-based compound is preferred from the viewpoint of easy availability and exposure latitude. The content of the ultraviolet ray absorber in the photosensitive resin composition is preferably 0.005 to 0.1% by mass.

In general, when a flexographic printing plate is produced from a flexographic printing plate precursor, four types of exposure, i.e., back exposure, main exposure, finishing exposure and the exposure with a germicidal lamp, are performed. Back exposure is performed for irradiating the whole area with light from the support side so as to form a floor part on the printing plate. Main exposure is performed for imagewise-irradiating a flexographic printing plate precursor with light through a mask and then crosslinking and curing an unsaturated compound in a lightirradiated part on the photosensitive resin layer, thereby forming an area that will become an image (dot part). Finishing exposure is performed for irradiating, with light, the whole are of the printing plate which has been developed after the main exposure and now has the dot part formed thereon. The role of finishing exposure is to compensate the insufficient crosslinking and curing by the main exposure and to crosslink and cure side surfaces of the dot convex of the dot part (dot side surface part) and a surface of the floor part. Exposure with a germicidal lamp is performed for removing the surface stickiness of the printing plate, and partially has a role of crosslinking and curing of side surfaces of the dot convex and a surface of the floor part, similar to the finishing exposure. In general, each of main exposure and finishing exposure is performed utilizing UVA, while exposure with a germicidal lamp is performed utilizing UVC.

The curing of side surfaces of the dot convex and a surface of the floor part by the finishing exposure and the exposure with a germicidal lamp has occurred to some extent in the conventional flexographic printing plate. The finishing exposure and the exposure with a germicidal lamp are generally performed under atmosphere. Therefore, polymerization is inhibited by the action of oxygen in the atmosphere. Therefore, in the conventional flexographic printing plate, the level of the curing of side surfaces of the dot convex and a surface of the floor part by the finishing exposure and the exposure with a germicidal lamp is not so high. In the present invention, in contrast, the influence of the polymerization inhibition by oxygen can be reduced satisfactorily and the side surfaces of the dot convex and a surface of the floor part can be cured sufficiently by adding the photopolymerization initiator in a larger amount compared with the conventional flexographic printing plate. As a result, the adhesiveness of the dot side surface part and the adhesiveness of the floor part can be reduced significantly.

If the content of the photopolymerization initiator is smaller than the above-mentioned preferred range, the reduction of the adhesiveness of the dot side surface part and the adhesiveness of the floor part may be insufficient. Consequently the ink entanglement may occur. If the content of the photopolymerization initiator is more than the above-mentioned preferred range, on the other hand, the curing upon the main exposure proceeds and as a result, the composite elastic modulus of the solid-printed part becomes too high and the ink laydown on solid-printed parts tends to be deteriorated.

As to the heat-sensitive mask layer (C) used in the flexographic printing plate precursor, any conventional one which has been used in a printing plate precursor can be used. For example, the heat-sensitive mask layer is preferably composed of carbon black (which is a material having the function to absorb infrared ray laser so as to convert the absorbed infrared ray laser to heat and the function to block ultraviolet ray), a dispersion binder for carbon black, and a binder polymer capable of forming a coating film. The dispersion binder may double with the binder polymer capable of forming a coating film. Furthermore, an auxiliary component other than the above-mentioned components, e.g., a pigment dispersing agent, a filler, a surfactant and a coating aid, may be contained, as long as the effects of the present invention cannot be deteriorated.

The heat-sensitive mask layer (C) used in the flexographic printing plate precursor of the present invention is preferably developable with water. Examples of the heat-sensitive mask layer (C) include: a heat-sensitive mask layer containing a combination of a polyamide containing a polar group and a butyral resin (Japanese Patent No. 4200510); a heat-sensitive mask layer containing a polymer having the same structure as that of the polymer in the photosensitive resin layer and an acrylic resin (Japanese Patent No. 5710961); and a heat-sensitive mask layer containing an anionic polymer and a polymer having an ester group in a side chain thereof and having a saponification degree of 0 to 90% inclusive (Japanese Patent No. 5525074).

Preferably, the flexographic printing plate precursor of the present invention is provided with an oxygen barrier layer (D) between the photosensitive resin layer (B) and the heat-sensitive mask layer (C). When an oxygen barrier layer (D) is provided, the oxygen-induced polymerization inhibition during main exposure can be inhibited, and a satisfactory curing reaction can occur. In this manner, a flat top suitable for printing is formed on the dot part. The formation of the flat top on each dot allows a stable printing. Examples of the binder polymer in the barrier layer include polyvinyl alcohol, partially saponified polyvinyl acetate, an alkyl cellulose, a cellulose-based polymer, and polyamide. These polymers may not be always used singly, or a combination of two or more of these polymers may be used. Examples of the binder polymer which are preferred from the viewpoint of oxygen barrier performance include polyvinyl alcohol, partially saponified polyvinyl acetate, and polyamide. By selecting a binder polymer having oxygen barrier performance within a preferred range, it is possible to control the image reproducibility appropriately.

The thickness of the barrier layer is preferably 0.2 to 3.0 µm and further preferably 0.2 to 1.5 µm. If the thickness is smaller than the above-mentioned range, the oxygen barrier performance may become insufficient and the printing surface of a relief may be roughened. If the thickness is more than the above-mentioned range, the deterioration in reproducibility of a fine line may occur.

Although a method for producing the flexographic printing plate precursor of the present invention is not particularly limited, it may be produced generally as mentioned below.

Firstly, components of heat-sensitive mask layer (C) such as binder other than the carbon black are dissolved in a suitable solvent, and then the carbon black is dispersed therein so as to prepare a dispersion. Then the dispersion is applied onto a support for the heat-sensitive mask layer (such as a polyethylene terephthalate film) . Then the solvent is evaporated therefrom. After that, a component for the oxygen barrier layer (D) is applied thereon whereupon one laminate is prepared. Further, apart therefrom, the photosensitive resin layer (B) is formed on another support (A) by means of application whereupon another laminate is prepared. The prepared two laminates are layered under pressurization and/or heating in such a manner that the photosensitive resin layer (B) adjacently contacts the oxygen barrier layer (D). Incidentally, after completion of the printing plate precursor, the support for the heat-sensitive mask layer functions as a protective film for a surface thereof.

Now, a method for producing a flexographic printing plate from this flexographic printing plate precursor produced as mentioned above will be explained. Firstly, the protective film (if any) is removed from the flexographic printing plate precursor. Thereafter, the heat-sensitive mask layer (C) is imagewise-irradiated with an IR laser so that a mask is formed on the photosensitive resin layer (B). Preferable examples of the IR laser include an ND/YAG laser (1064 nm) and a diode laser (for example, 830 nm). A laser system suitable for the Computer to Plate Technique is commercially available, and, for example, CDI (manufactured by Esko-Graphics Co., Ltd.) may be used. This laser system includes a rotation cylinder drum used for holding a printing plate precursor, an IR laser irradiating device and a layout computer. Pattern information is directly transferred from the layout computer to the laser device.

After the pattern information has been written in the heat-sensitive mask layer (C), the entire surface of the flexographic printing plate precursor is irradiated with active light rays via the imagewise-mask (main exposure). This process may be carried out with the plate attached to the laser cylinder; however, a method is generally used in which, after the plate has been removed from the laser device, the irradiation process is carried out by using a commonly-used irradiation unit having a flat plate shape because this method is more advantageous in that even a plate size out of the standard can be appropriately handled. Examples of the active light rays include: ultraviolet rays having an emission peak at a wavelength in a range from 330 to 380 nm. Examples of its light source include: a low-pressure mercury lamp, a highpressure mercury lamp, a super-high pressure mercury lamp, a metal halide lamp, a xenon lamp, a zirconium lamp, a carbon arc lamp and an ultraviolet-ray fluorescent lamp. Thereafter, the irradiated plate is developed, subjected to finishing exposure, and subjected to exposure with a germicidal lamp whereby the printing plate is obtained. The development step can be performed with a conventional development unit.

In a flexographic printing plate prepared as above, the adhesion force of the floor part (dot side surface part) on the printing plate is 2.0 N/mm² or less, preferably 1.5 N/mm² or less, more preferably 1.0 N/mm² or less. The flexographic printing plate according to the present invention has these characteristic properties. Therefore, the problem of ink entanglement, i.e., the direct connection of ink on a dot convex part to ink on an adjacent convex part, can be reduced substantially in an actual printing procedure. When ink entanglement occurs, ink on a dot convex part is connected to ink on an adjacent dot convex part, which may greatly deteriorate printing quality. In the flexographic printing plate according to the present invention, the adhesion of dusts during a printing procedure can be reduced and therefore printing defect due to the adhesion of dusts can also be reduced by decreasing the adhesion force of the floor part. Regarding the reason why the ink entanglement can be reduced by decreasing the adhesion force of the floor part (i.e., the adhesion force of a dot side surface part), it is supposed that the curing of the surface of the floor part (i.e., the curing of the surface of the dot side surface side) becomes sufficient and consequently the compatibility with the ink is reduced.

In the present invention, the measurement of the adhesion force of a floor part was performed by the following specific method.

The measurement of the adhesion force of a floor part was performed using a universal material test machine RTC1210A manufactured by Orientec Co., Ltd. A flexographic printing plate to be measured with respect to the adhesion force thereof was fixed and placed at each of an upper part and a lower part of the machine. Then floor parts on the flexographic printing plates arranged at the upper and lower parts were closely adhered to each other at 20 N/mm² for 60 seconds. Then the flexographic printing plates were detached from each other at a peeling speed of 1 mm/min. The maximum load in this detachment was employed as a value for the adhesion force. The measurement was performed 10 times under an environment having a temperature of 25°C and a humidity of 50 RH%, and an average value of the measurement values was determined. In this experiment, a square-shaped flexographic printing plate having a size of 30 mm × 30 mm was used for the lower part, while a disclike flexographic printing plate having a circumference of 10 mm was used for the upper part.

A printing plate to be used in the measurement of the adhesion force of a floor part was produced under the following conditions. Back exposure, main exposure and finishing exposure were performed using TL-K 40W/10R lamp (peak wavelength: 370 nm, luminance at 350 nm: 10 mW/cm²) manufactured by Philips. As to the germicidal lamp, a germicidal lamp GL-40 (peak wavelength: 250 nm, luminance at 250 nm: 4.5 mW/cm²) manufactured by Panasonic Corporation. The imaging of the heat-sensitive mask layer was per formed using CDI 4850 manufactured by ESCO Graphics at a resolution of 4000 dpi. An image to be evaluated was one having at least dots (at 175 lpi, 0 to 10%, in 0.3% increment), dots (at 175 lpi, 10 to 100%, in 5% increment), a floor part, and isolated dots (between 0 to 300 µm, in 50 µm increment). The amount of back exposure was adjusted to a time at which the relief depth could become 0.6 mm. The amount of main exposure was adjusted to a time at which 1% dots (diameter: 16 pm) was reproduced on the printing plate. After a development step and a subsequent drying step were performed, finishing exposure was performed for 7 minutes, and finally the plate was irradiated with a germicidal lamp for 5 minutes so as to prepare a printing plate.

### Examples

As hereunder, the effects of the printing plate of the present invention will be illustrated by referring to the following Examples although the present invention is not limited to those Examples. A term "part(s)" in Examples stand(s) for part(s) by mass. Values shown in Tables which indicate a composition ratio also stand for part(s) by mass.

Evaluation in Examples was done in accordance with the following methods.

### (1) Adhesion force of floor part

The measurement of the adhesion force of a floor part was performed using a universal material test machine RTC1210A manufactured by Orientec Co., Ltd. A flexographic printing plate to be measured with respect to the adhesion force thereof was fixed and placed at each of an upper part and a lower part of the machine. Then floor parts on the flexographic printing plates arranged at the upper and lower parts were closely adhered to each other at 20 N/mm² for 60 seconds. Then the flexographic printing plates were detached from each other at a peeling speed of 1 mm/min. The maximum load in this detachment was employed as a value for the adhesion force. The measurement was performed 10 times under an environment having a temperature of 25°C and a humidity of 50 RH%, and an average value of the measurement values was determined. In this experiment, a square-shaped flexographic printing plate having a size of 30 mm × 30 mm was used for the lower part, while a disclike flexographic printing plate having a circumference of 10 mm was used for the upper part.

### (2) Ink entanglement

Regarding the produced flexographic printing plate, ink entanglement was evaluated using a flexographic printing machine FPR302 (manufactured by MCK Corporation) and using Anilox of 900LPI. The ink used was a water-based ink (product name: Marine Flex LM (manufactured by DIC Corporation)). As to the object to be printed, a PP film (product name: P4256, manufactured by Toyobo Co., Ltd.) was used. The printing speed was 50 m/min. A position in which the printing plate contacted with the object to be printed was defined as zero. The indentation depth in printing was determined as a position at which the indenter was pushed into a depth of 90 µm from the zero position. Printing was performed at a length of 10000 m. The ink entanglement was evaluated in accordance with the following criteria.
5 points: ink entanglement was not observed after the printing at a length of 10000 m.
4 points: slight ink entanglement was observed in some dots after the printing at a length of 10000 m.
3 points: ink entanglement was observed after the printing at a length of 10000 m.
2 points: ink entanglement was observed after the printing at a length of 5000 m.
1 point: ink entanglement was observed after the printing at a length of 1000 m.

### (3) Reproducibility of isolated dot

The reproducibility of a minimum isolated dot on the printing plate was measured. A minimum isolated dot having a size of 50 µm or less was rated as "oo", a minimum isolated dot having a size of larger than 50 µm and not larger than 100 µm was rated as "o", a minimum isolated dot having a size of larger than 100 µm and not larger than 200 µm was rated as "Δ", and a minimum isolated dot having a size of larger than 200 µm was rated as "×". A smaller size of the reproduced minimum isolated dot means that the reproducibility of an isolated dot was superior.

### (4) Durability of printing plate

Regarding the flexographic printing plate produced in Example 1, durability of printing plate was evaluated using a flexographic printing machine FPR302 (manufactured by MCK Corporation) and using Anilox of 900LPI. As to the ink, an UV ink (product name: FLEXOCURE CYAN (manufactured by Flint)) was used. As to an object to be printed, coat paper (product name: Pearl Coat (manufactured by Oji Paper Co., Ltd.)) was used. The printing speed was 50 m/min. A position in which the printing plate contacted with the object to be printed was defined as zero. The indentation depth in printing was determined as a position at which the indenter was pushed into a depth of 150 µm from the zero position. Printing was performed at a length of 5,000 m by this printing method. Dots each having a diameter of 16 µm on the plate after the printing were observed with a microscope. A dot of which the appearance was not changed before and after the printing was rated as "oo", a dot which was slightly abraded only at an edge part was rated as "o", a dot which was partially lack or abraded was rated as "Δ", and a dot which was entirely lack or abraded was rated as "×".

### Example 1

### Preparation of photosensitive resin composition

A butadiene latex (Nipol LX111NF, non-volatile content: 55%, manufactured by Zeon Corporation) (86 parts by mass) that served as the polymer prepared by polymerizing a conjugated diene, an acrylonitrile-butadiene latex (Nipol SX1503, non-volatile content: 42%, manufactured by Zeon Corporation) (24 parts by mass) that served as the polymer prepared by polymerizing a conjugated diene, a polybutadiene-terminal acrylate having a number average molecular weight of 10000 (BAC45, manufactured by Osaka Organic Chemical Industry Ltd.) (15 parts by mass) that served as an ethylenically unsaturated compound, trimethylolpropane trimethacrylate having a number average molecular weight of 338 (Light Ester TMP, manufactured by Kyoeisha Chemical Co., Ltd.) (10 parts by mass) that served as ethylenically unsaturated compound, benzyl dimethylketal (3 parts by mass) that served as a photopolymerization initiator, and a hydrophilic polymer (PFT-4, non-volatile content: 25%, manufactured by Kyoeisha Chemical Co., Ltd.) (20 parts by mass), a butadiene oligomer (B2000, manufactured by Nippon Soda Co., Ltd.) (9.9 parts by mass), a thermal stabilizer (4-methoxyphenol) (0.1 part by mass), and an ultraviolet ray absorber (Tinuvin 326) (0.01 part by mass) that served as auxiliary components were mixed together in a container so as to produce a dope. The dope was charged into a pressurized kneader, and then the solvent was removed under a reduced pressure at 80°C so as to produce a photosensitive resin composition.

### Preparation of flexographic printing plate precursor

Carbon black dispersion (AMBK-8 manufactured by ORIENT CHEMICAL INDUSTRIES CO., LTD.), copolymerized polyamide (PA223 manufactured by TOYOBO CO., LTD.), propylene glycol, and methanol were mixed at a mass proportion of 45/5/5/45 so as to obtain an heat-sensitive mask layer coating solution. After a releasing treatment was performed on both sides of a PET film (E5000 manufactured by TOYOBO CO., LTD., thickness: 100 µm), the heat-sensitive mask layer coating solution was applied onto the PET film using a bar coater so that a thickness of a coating film after being dried was 2 µm, and dried at 120°C for 5 minutes so as to obtain a film laminate (I). An optical density thereof was 2.3. The optical density was measured using a black-and-white transmission densitometer DM-520 (SCREEN Holdings Co., Ltd.). Polyvinyl acetate (KH20 manufactured by NIHON GOSEI KAKO Co., Ltd.) having a saponification degree of 80% and a plasticizer (glycerin) were mixed at a mass proportion of 70/30 so as to obtain an oxygen barrier layer coating solution. The oxygen barrier layer coating solution was applied onto the film laminate (I) using a bar coater so that a thickness of a coating film after being dried was 2.0 µm, and dried at 120°C for 5 minutes so as to obtain a film laminate (II). The photosensitive resin composition was disposed on a PET film support (E5000 manufactured by TOYOBO CO., LTD., thickness: 125 µm) coated with a copolymerized polyester-based adhesive, and the film laminate (II) was superposed on the photosensitive resin composition. These were laminated at 100°C using a heat pressing machine so as to obtain a flexographic printing plate precursor including a PET support, an adhesive layer, a photosensitive resin layer, an oxygen barrier layer, a heat-sensitive mask layer, and a cover film. A total thickness of the plate was 1.14 mm.

### Preparation of printing plate from flexographic printing plate precursor

The printing plate precursor was subjected to back exposure from the PET support side for 10 seconds. Subsequently, the cover film was peeled off. This plate was wound around CDI4530 (manufactured by ESCO Graphics), and was then subjected to abrasion at a resolution of 4000dpi using a test image having dots (at 175 lpi, 0 to 10%, in 0.3% increment), dots (at 175 lpi, 10 to 100%, in 5% increment), a floor part, and isolated dots (between 0 to 300 µm, in 50 µm increment). After the ablation, the plate was taken out, returned to the plane shape, and subjected to main exposure for 7 minutes. Thereafter, development was performed for 8 minutes using a developing machine (Stuck System, 1% aqueous washing soap solution, 40°C) manufactured by A & V Co., Ltd., and water droplets on the plate surface were removed with a drain stick. Thereafter, the plate was dried in a dryer at 60°C for 10 minutes, subjected to finishing exposure for 7 minutes, and finally irradiated with light from a germicidal lamp for 5 minutes, whereby a flexographic printing plate was thus obtained. The back exposure, main exposure and finishing exposure were performed using TL-K 40W/10R lamp (peak wavelength: 370 nm, luminance at 350 nm: 10 mW/cm²) manufactured by Philips. As to the germicidal lamp, a germicidal lamp GL-40 (peak wavelength: 250 nm, luminance at 250 nm: 4.5 mW/cm²) manufactured by Panasonic Corporation was used. It was confirmed that the relief depth of the resultant printing plate was 0.6 mm and dots each having a diameter of 16 µm were reproduced on the printing plate.

### Examples 2 to 14 and Comparative Examples 1 to 3

Flexographic printing plate precursors were prepared in the same manner as in Example 1 except that the composition ratio of each component in the photosensitive resin composition constituting the photosensitive resin layer was changed as presented in Tables 1 and 2. The time of back exposure was adjusted so that the relief depth became 0.6 mm, and the time of main exposure was adjusted to a time at which dots each having a diameter of 16 µm were reproduced on the printing plate.

### Example 15

Flexographic printing plate precursors were prepared in the same manner as in Example 1 except that, to the components constituting the photosensitive resin layer, X22 1660B-3 manufactured by Shin-Etsu Chemical Co., Ltd. (the silicone compound having an amino group and a phenyl group in the molecule) (amino group equivalent: 2200 g/mol, phenyl group equivalent: 210 g/mol, number average molecular weight: 4400) was further added as the silicone compound, and that the composition ratio of each component in the photosensitive resin composition constituting the photosensitive resin layer was changed as presented in Tables 1 and 2. The time of back exposure was adjusted so that the relief depth became 0.6 mm, and the time of main exposure was adjusted to a time at which dots each having a diameter of 16 µm were reproduced on the printing plate.

Evaluation results of Examples 1 to 15 and Comparative Examples 1 to 3 are shown in Tables 1 and 2.

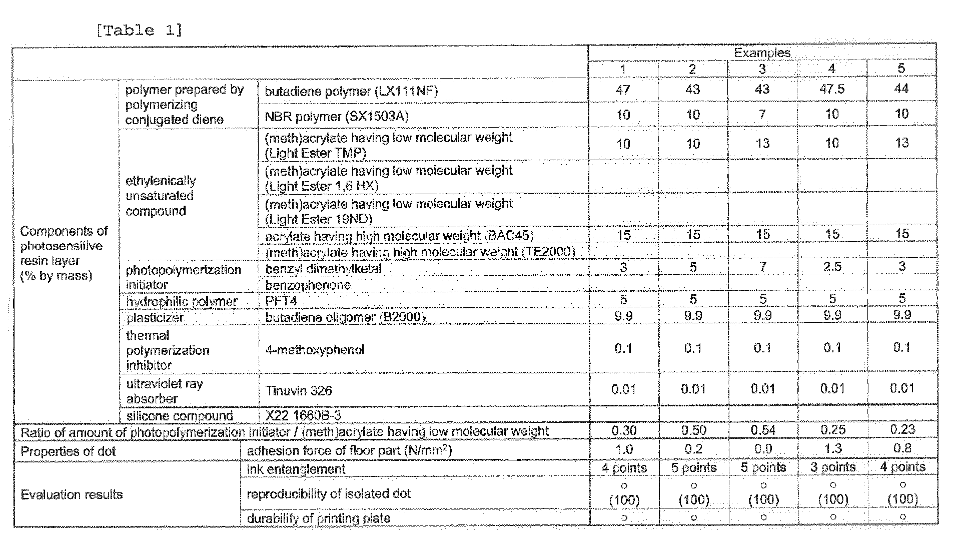

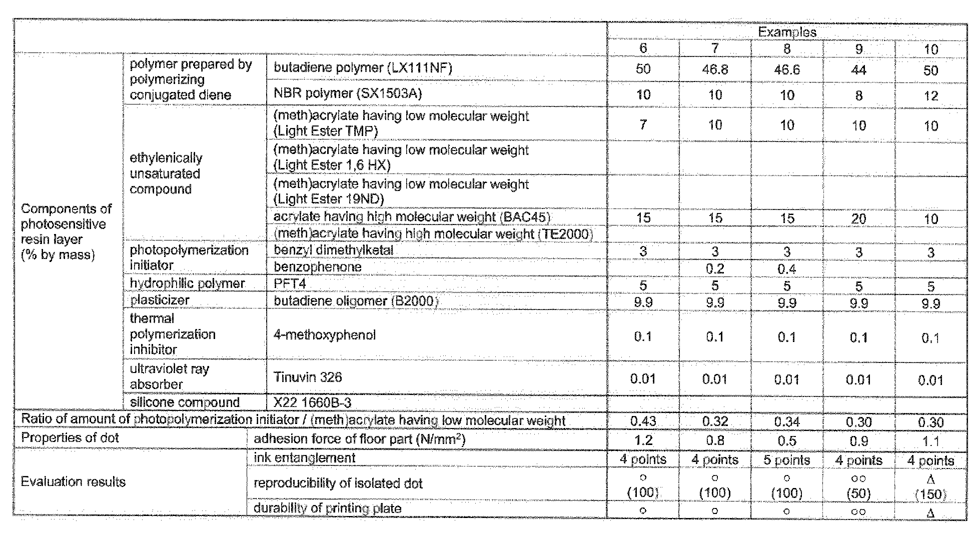

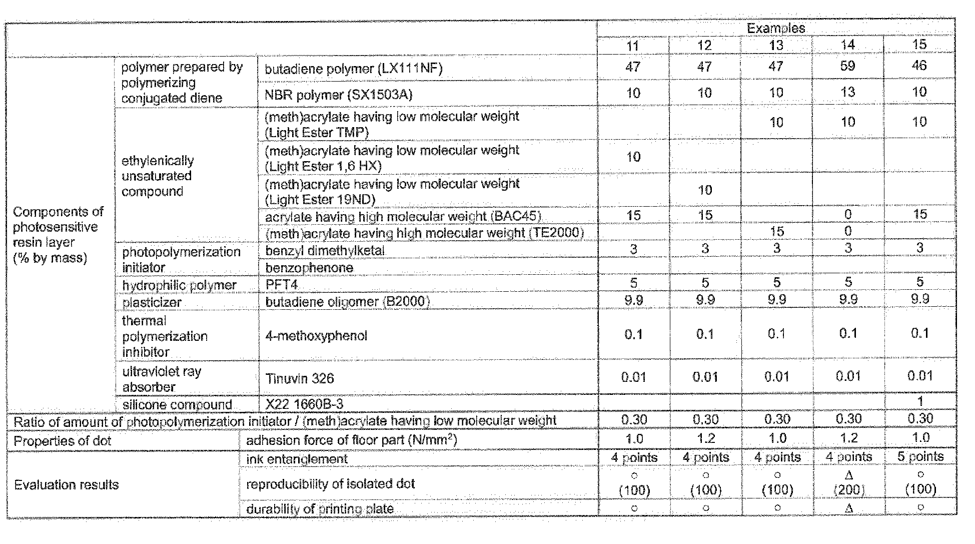

**[Table 2]**

| | | | | Comparative Examples | | |
|---|---|---|---|---|---|---|
| | | | | 1 | 2 | 3 |
| Components of photosensitive resin layer (% by mass) | polymer prepared by polymerizing conjugated diene | | butadiene polymer (LX111NF) | 49 | 50.5 | 52 |
| | | | NBR polymer (SX1503A) | 10 | 12 | 12 |
| | ethylenically unsaturated compound | | (meth)acrylate having low molecular weight (Light Ester TMP) | 10 | 6 | 3 |
| | | | (meth)acrylate having low molecular weight (Light Ester 1,6 HX) | | | |
| | | | (meth)acrylate having low molecular weight (Light Ester 19ND) | | | |
| | | | acrylate having high molecular weight (BAC45) | 15 | 15 | 15 |
| | | | (meth)acrylate having high molecular weight (TE2000) | | | |
| | photo polymerization initiator | | benzyl dimethylketal | 1 | 1.5 | 3 |
| | | | benzophenone | | | |
| | hydrophilic polymer | | PFT4 | 5 | 5 | 5 |
| | plasticizer | | butadiene oligomer (B2000) | 9.9 | 9.9 | 9.9 |
| | thermal polymerization inhibitor | | 4-methoxyphenol | 0.1 | 0.1 | 0.1 |
| | ultraviolet ray absorber | | Tinuvin 326 | 0.01 | 0.01 | 0.01 |
| Ratio of amount of photopolymerization initiator / (meth)acrylate having low molecular weight | | | | 0.10 | 0.25 | 1.00 |
| Properties of dot | | adhesion force of floor part (N/mm²) | | 3.0 | 2.8 | 2.5 |
| Evaluation results | | ink entanglement | | 1 point | 2 points | 2 points |
| | | reproducibility of isolated dot | | ∘ (100) | ∘ (100) | ∘ (100) |
| | | durability of printing plate | | ∘ | ∘ | ∘ |

Details of the ethylenically unsaturated compound in the above Tables are as follows.

Light Ester TMP: Trimethylolpropane tri(meth)acrylate, number average molecular weight: 338, manufactured by Kyoeisha Chemical Co., Ltd.

Light Ester 1,6 HX: 1,6-hexanediol dimethacrylate, number average molecular weight: 254, manufactured by Kyoeisha Chemical Co., Ltd.

Light Ester 19ND: 1,9-nonanediol di(meth)acrylate, number average molecular weight: 298, manufactured by Kyoeisha Chemical Co., Ltd.

BAC45: Polybutadiene-terminal acrylate, number average molecular weight: 10000, manufactured by Osaka Organic Chemical Industry Ltd.

TE2000: Polybutadiene having a methacrylate group introduced at terminal thereof, urethane-bonded type, number average molecular weight: 3,000, manufactured by Nippon Soda Co., Ltd.

As apparent from the evaluation results shown in the table, in Examples 1 to 15 in which the adhesion force of a floor part (i.e., the adhesion force of a dot side surface part) was within the range defined by the present invention, ink entanglement occurred to a reduced extent. As to the method for adjusting the adhesion force of a floor part (i.e., the adhesion force of a dot side surface part) to a value within the range defined in the present invention, it is critical that: the photopolymerization initiator is added in a larger amount compared with the conventional flexographic printing plate; a (meth)acrylate compound having a low molecular weight is added in a specified amount; and the ratio of the amount of the photopolymerization initiator to the amount of the (meth)acrylate compound having a low molecular weight is adjusted to a value within a specified range. In addition, by further adding a (meth)acrylate compound having a high molecular weight, even when the photopolymerization initiator is added in a larger amount, the reproducibility of isolated dots and the durability of a printing plate are not deteriorated (see the comparison between Examples 1 to 8, 11 to 13, and 15 with Examples 9, 10, and 14). Furthermore, by using benzophenone in combination with the photopolymerization initiator, the adhesion force of a floor part (i.e., the adhesion force of a dot side surface part) can be reduced (see the comparison between Examples 1 to 6 and 9 to 15 with Examples 7 and 8). Furthermore, by adding the silicone compound, the ink entanglement can be further effectively prevented (see the comparison between Examples 1 to 14 with Example 15).

In contrast, in Comparative Example 1, because the amount of the photopolymerization initiator added was small which was the same amount level as that employed conventionally, the adhesion force of a floor part (i.e., the adhesion force of a dot side surface part) was high and thus the ink entanglement could not be suppressed. In Comparative Example 2, because the amount of the photopolymerization initiator added was small, even when the ratio of the amount of the photopolymerization initiator to the amount of the (meth)acrylate compound having a low molecular weight was proper, the adhesion force of a floor part was high and thus the ink entanglement could not be suppressed. In Comparative Example 3, because the amount of the (meth)acrylate compound having a low molecular weight added was small, the adhesion force of a floor part (i.e., the adhesion force of a dot side surface part) was high and thus the ink entanglement could not be suppressed.

### Industrial Applicability

In the flexographic printing plate according to the present invention, the adhesion force of a floor part (i.e., the adhesion force of a dot side surface part) is reduced to a specific value. Therefore, the ink entanglement, i.e., the connection of ink on a dot convex part to ink on an adjacent dot convex part, can be reduced. As a result, the flexographic printing plate according to the present invention is free from the decrease in printing quality caused from the ink entanglement. Therefore, the flexographic printing plate of the present invention is very useful in the industrial field.

## Claims

1. A flexographic printing plate obtained from a flexographic printing plate precursor comprising at least a support (A), a photosensitive resin layer (B) and a heat-sensitive mask layer (C) which are laminated in this order, wherein, on a surface of the printing plate, there are provided dot convex parts, a dot valley part formed between the dot convex parts, and a floor part, and wherein a side surface of the dot valley part and the floor part have been subjected to the same finishing exposure treatment and the same exposure treatment using a germicidal lamp, **characterized in that** the adhesion force of the floor part on the printing plate is 2.0 N/mm² or less.

2. The flexographic printing plate according to claim 1, wherein a photosensitive resin composition constituting the photosensitive resin layer (B) comprises (a) a polymer prepared by polymerizing a conjugated diene, (b) an ethylenically unsaturated compound and (c) a photopolymerization initiator, wherein the content of the photopolymerization initiator (c) in the photosensitive resin composition is 2 to 9% by mass, wherein the ethylenically unsaturated compound (b) includes a (meth)acrylate compound (i) having a number average molecular weight of 100 to 600, wherein the content of the (meth)acrylate compound (i) having a number average molecular weight of 100 to 600 in the photosensitive resin composition is 5 to 16% by mass, and wherein the ratio of the mass of the photopolymerization initiator (c) and the mass of the (meth)acrylate compound (i) having a number average molecular weight of 100 to 600 in the photosensitive resin composition is within the range of 0.20 to 0.55.

3. The flexographic printing plate according to claim 2, wherein the ethylenically unsaturated compound (b) further includes a (meth)acrylate compound (ii) having a number average molecular weight of more than 600 and not more than 20,000, and wherein the content of the (meth)acrylate compound (ii) having a number average molecular weight of more than 600 and not more than 20,000 in the photosensitive resin composition is 5 to 25% by mass.

4. The flexographic printing plate according to claim 2 or 3, wherein the photopolymerization initiator (c) includes two types of compounds which are a benzyl alkyl ketal compound and a benzophenone compound, and wherein the ratio of the mass of the benzyl alkyl ketal compound to the mass of the benzophenone compound is within the range of 99:1 to 80:20.

5. The flexographic printing plate according to any of claims 1 to 4, wherein the flexographic printing plate precursor has an oxygen barrier layer (D) between the photosensitive resin layer (B) and the heat-sensitive mask layer (C).

6. The flexographic printing plate according to any of claims 1 to 5, wherein the flexographic printing plate has been obtained by developing the flexographic printing plate precursor using a water-based developing solution.

7. A flexographic printing method, **characterized in that** the method uses the flexographic printing plate according to any of claims 1 to 6.
